# EUROPÄISCHE PATENTSCHRIFT

(11) **EP 1 988 810 B1**
(45) Veröffentlichungstag und Bekanntmachung des Hinweises auf die Patenterteilung: **14.03.2018**
(21) Anmeldenummer: 07712027.7
(22) Anmeldetag: 15.01.2007
(51) Int. Cl.: F04D 29/043, H02K 5/12, H02K 5/128, H02K 7/00, A47L 15/42, D06F 39/08

(54) **WASSERFÜHRENDES HAUSHALTSGERÄT MIT VERBESSERTER WELLE**
WATER-CONDUCTING HOUSEHOLD DEVICE HAVING AN IMPROVED SHAFT
APPAREIL MÉNAGER À CIRCULATION D'EAU À ARBRE AMÉLIORÉ

(30) Priorität: 24.02.2006 DE 102006008762
(43) Veröffentlichungstag der Anmeldung: 12.11.2008
(73) Patentinhaber: BSH Hausgeräte GmbH, 81739 München (DE)
(72) Erfinder: ERTLE, Erika Ulrike, 89415 Lauingen (DE); ERTLE, Marion, 89415 Lauingen (DE); ERTLE, Lisa Marie, 89415 Lauingen (DE); ERTLE, Marco Andreas, 89415 Lauingen (DE); REITER, Bruno, 73450 Neresheim (DE); WAGNER, Franz-Josef, 86720 Nördlingen (DE)
(86) Internationale Anmeldenummer: PCT/EP2007/050316
(87) Internationale Veröffentlichungsnummer: WO 2007/098976

(56) Entgegenhaltungen:
- DE-A1- 1 750 878
- DE-A1- 19 508 085
- JP-A- 6 341 438
- JP-A- 11 125 243
- US-A- 3 186 778
- US-A- 3 951 759
- US-A1- 2002 154 840
- US-B1- 6 271 612

## Beschreibung

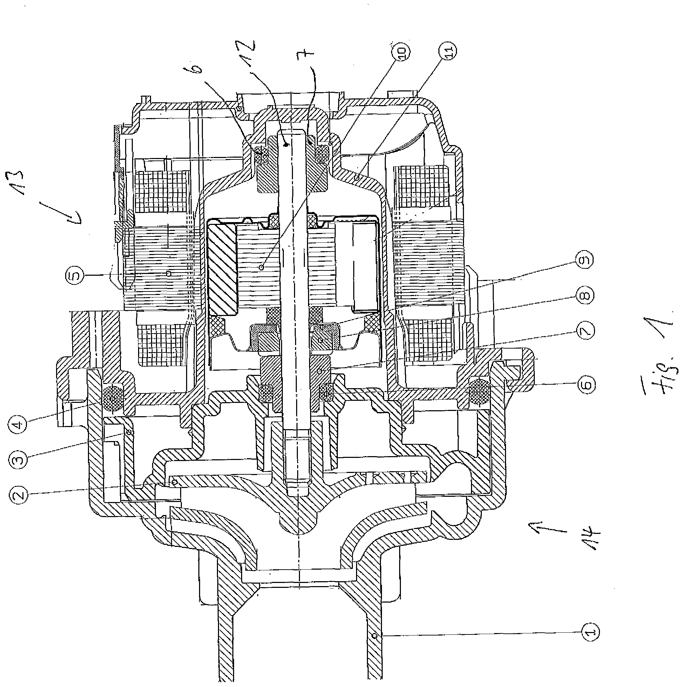

Die Erfindung betrifft ein wasserführendes Haushaltsgerät, z. B. eine Geschirrspülmaschine, mit einem beweglichen von einem Gleitlager zu lagernden Gegenstand, wobei auf dem beweglichen Gegenstand eine Beschichtung angeordnet ist.
In wasserführenden Haushaltsgeräten, z. B. in Geschirrspülmaschinen oder Waschmaschinen werden so genannte Nassläuferpumpen eingesetzt. Die Ausführung der Wellenlager erfolgt als Radialgleitlager, welche bei Nassläuferpumpen von der entsprechenden Reinigungsflüssigkeit, im Wesentlichen Wasser, umspült werden. Die Reinigungsflüssigkeit, als das von der Pumpe zu fördernde Medium, enthält häufig korrosionsfördernde Stoffe, z. B. Chlorid aus dem Brauch- oder Trinkwasser oder ein bedingt durch die Enthärtungsanlage der Geschirrspülmaschine. Um Korrosion an der Welle zu vermeiden, werden deshalb oftmals Edelstahlwellen eingesetzt. In der Reinigungsflüssigkeit befinden sich häufig Feststoffe, z. B. Sand, Silikate oder Metalle, die teilweise abrasive Anteile aufgrund der Abtragung aus Feststoffen, z. B. der Lagerung oder der Welle, sind. Edelstahlwellen besitzen jedoch eine geringe Oberflächenhärte, so dass bei Anwesenheit von entsprechenden Feststoffteilen in der Flüssigkeit als Suspension dies zu einem Aufrauhen der Oberfläche der Edelstahlwelle und dadurch zu einem frühzeitigen Versagen des Radiallagers aufgrund erhöhter Reibung führt.
Beim Einsatz von gehärteten Stählen tritt im Allgemeinen Versagen aufgrund Korrosion auf, weil gehärteter Stahl mit Kohlenstoff versetzt ist. Auch das beispielsweise galvanische Aufbringen von Hartmetallschichten, z. B. aus Chrom, führt aufgrund von Abplatzungen zum Versagen des Radiallagers. Wellen aus oxidkeramischen Werkstoffen sind in der Herstellung teurer und aufgrund der Eigenschaften von oxidkeramischen Werkstoffen in Formgebung und Verarbeitung nur bedingt einsatzfähig. Darüber hinaus sind Wellen aus oxidkeramischen Werkstoffen bei Radiallagern nicht trockenlaufbeständig.
Die JP 11- 125243 A beschäftigt sich mit der möglichst reibungsarmen Axiallagerung ("thrust bearing") des Endes einer Welle ("rotary shaft 2") (siehe Abschnitt [0009]), die an ihrem freien Endabschnitt eine Polygonspiegel R1 zur Lichtablenkung aufweist (siehe die Figuren 1, 3, 7 und claims 3, 4). Dieser rotierbar gelagerte Ablenkspiegel R1 wird in bildgebenden Geräten wie z.B. Laserdruckern oder Laserfaxe verwendet (siehe Abschnitt [0001]). An solche Lichtablenkspiegel wird im Abschnitt [0004] für schnelle und qualitativ verbesserte Bildwiedergaben gefordert, dass "rotation unvenness of rotating polygon Ro is small and that there are little vibration, noise, etc....".

Aufgabe der vorliegenden Erfindung ist es daher, ein wasserführendes Haushaltsgerät mit einer kostengünstigen Antriebswelle zur Verfügung zu stellen, welche auch bei einer Nasslagerung mit korrosionsfördernde Stoffe und Feststoffteilchen enthaltenden Flüssigkeiten funktionstüchtig ist und über gute Trockenlaufeigenschaften verfügt.
Diese Aufgabe wird durch ein erfindungsgemäßes Haushaltsgerät nach Patentanspruch 1 gelöst. Vorteilhafte Ausgestaltungen sind Gegenstand der abhängigen Patentansprüche.

In einem erfindungsgemäßen wasserführenden Haushaltsgerät, z. B. Geschirrspülmaschine oder Waschmaschine, mit einem beweglichen, von einem Gleitlager zu lagernden Gegenstand, wobei auf dem beweglichen Gegenstand eine Beschichtung, insbesondere mit einem metallischen Element, angeordnet ist, umfasst die Beschichtung wenigstens ein nichtmetallisches Element mit einem Stoffmengenanteil von wenigstens einem 1%, wobei die Härte der Beschichtung wenigstens 800 HV, insbesondere wenigstens 2000 HV, beträgt. Dabei umfasst die Beschichtung wenigstens ein nichtmetallisches Element. Der Stoffmengenanteil in mol des nichtmetallischen Elements bzw. der nichtmetallischen Elemente, z. B. Stickstoff, ist beispielsweise größer als 3%, insbesondere größer als 25%. In Stoffen für Beschichtungen sind häufig Spuren, d. h. sehr geringe Anteile, z. B. im Bereich kleiner als 0,5% Stoffmengenanteil, von Elementen, z. B. Sauerstoff oder Kohlenstoff, vorhanden. Es handelt sich insbesondere um eine Beschichtung aus Keramik oder Keramik ähnlichen Stoffen. Vorzugsweise besteht die Beschichtung aus einer chemischen Verbindung mit wenigstens einem nichtmetallischen Element und wenigstens einem metallischen Element.

Vorzugsweise ist das wenigstens eine nichtmetallische Element beispielsweise ein Element aus der Gruppe der Halogene, aus der Sauerstoffgruppe oder aus der Stickstoffgruppe oder Kohlenstoff. Unter nichtmetallischen Elementen werden auch Edelgase verstanden.

Insbesondere umfasst die Beschichtung wenigstens ein metallisches Element mit einem Stoffmengenanteil von wenigstens einem 1%.

Vorzugsweise sind die metallischen Elemente beispielsweise Elemente aus der Gruppe der Alkalimetalle, der Erdalkalimetalle oder der Erdmetalle oder z. B. Blei oder Zinn.

Vorzugsweise ist das Material der Beschichtung eine chemische Verbindung aus wenigstens einem metallischen Element und wenigstens einem nichtmetallischen Element.

Vorzugsweise ist die Beschichtung durch physikalisches Abscheiden aus der Gasphase (PVD-Verfahren), z. B. Bedampfen, Sputtern, Plasmavakuumverfahren oder Ionenimplantieren, aufgebracht.

In einer weiteren Ausführungsform ist die Beschichtung durch Abscheiden aus der Dampfphase, z. B. thermisches CVD, Plasma-CVD, Photonen-CVD oder laserinduziertes CVD, aufgebracht.

In einer ergänzenden Ausgestaltung ist die Beschichtung durch chemische Beschichtungsverfahren, z. B. Galvanisieren, aufgebracht.

Vorzugsweise enthält die Beschichtung Chrom- und/oder Stickstoff und besteht insbesondere aus einer Chrom-Stickstoffverbindung. Das metallische Element ist somit Chrom und das nichtmetallische Element Stickstoff. Neben diesen Elementen können auch andere chemische Elemente eingesetzt werden. Es kann sich z. B. um Titannnitrid handeln, das jedoch aufgrund der größeren Härte gegenüber einer Chromstickstoffverbindung zu Abplatzungen neigt und somit weniger geeignet ist.

Vorzugsweise liegt die Dicke der Beschichtung zwischen 0,1 µm und 20 µm, insbesondere im Bereich von 5 µm.

Erfindungsgemäß ist der bewegliche Gegenstand eine Welle, die von einem Radiallager gelagert ist.

Erfindungsgemäß ist die Welle von einem Elektromotor antreibbar.

Erfindungsgemäß ist von der Welle ein Flügelrad bzw. ein Propeller einer Pumpe antreibbar.
Erfindungsgemäß ist die Radiallagerung der Welle als Nasslagerung ausgeführt.

In einer weiteren Ausführungsform besteht das Radiallager aus gesintertem Kohlenstoff besteht und ist vorzugsweise als gesonderte Lagerbuchse ausgeführt. Neben gesintertem Kohlenstoff kann beispielsweise auch Kunststoff, z. B. thermoplastischer Kunststoff, für das Radiallager eingesetzt werden.

In einer ergänzenden Ausgestaltung sind der Elektromotor und/oder die Nassläuferpumpe und/oder die Lagerbuchse in einem Gehäuse aus Kunststoff angeordnet.

Vorzugsweise ist das Gehäuse mehrteilig.

In einer weiteren Ausführungsform besteht die Welle aus Edelstahl. Dadurch ist die Welle korrosionsbeständig.

In einem erfindungsgemäßen Beschichtungsverfahren für eine Welle eines Haushaltsgerätes wird die Beschichtung durch ein PVD-Verfahren, ein chemisches Beschichtungsverfahren oder ein CVD-Verfahren aufgebracht.

Insbesondere besteht die Beschichtung aus einer Chrom-Stickstoffverbindung.

Die Erfindung wird nachfolgend anhand einer Zeichnung beispielhaft erläutert. Es zeigt:
- Fig. 1: einen Querschnitt durch eine Nassläuferpumpe mit Elektromotor für eine Geschirrspülmaschine

In einer erfindungsgemäßen Geschirrspülmaschine (nicht dargestellt) ist eine Nassläuferpumpe 14 angeordnet. Ein Elektromotor 13 treibt über eine Welle 12 das Flügelrad 2 der Nassläuferpumpe 14 an. Das Flügelrad 2 ist von einem äußeren Pumpengehäuse 1 und einem inneren Pumpengehäuse 3 umgeben. Zwischen dem äußeren Pumpengehäuse 1 und dem Motorgehäuse 11 ist ein Ring 4 angeordnet. Ein Rotor 10 wird von einem Stator 5 angetrieben. Der Rotor 10 ist fest mit der Welle 12 verbunden. Die Welle 12 ist von einem Radiallager als Lagerbuchse 7 gelagert. Die Lagerbuchse 7 besteht vorzugsweise aus gesintertem Kohlenstoff. Die Lagerbuchse 7 ist über einen Ring 6 mit dem inneren Pumpengehäuse 3 bzw. dem Motorgehäuse 11 verbunden. Außerdem wird die Welle 12 von einem Keramikring 8 umgeben, wobei der Keramikring 8 von einer Gummilagerung 9 gelagert ist.

Die Reinigungsflüssigkeit in der erfindungsgemäßen Geschirrspülmaschine umspült die Welle 12 und auch den Rotor 10. Reinigungsflüssigkeit tritt somit auch im Spalt zwischen der Welle 12 und der Lagerbuchse 7 auf.

Die Welle 12 besteht aus Edelstahl und ist mit einem Stoff überzogen, der ein nichtmetallisches Element, z. B. Stickstoff, enthält. Die Härte der Beschichtung ist größer als 1.000 HV (Vickers Härte), insbesondere größer als 1.500 oder 2.000 HV. Vorzugsweise besteht die Beschichtung aus einer Chrom-Stickstoffverbindung. Die Beschichtung aus der Chrom-Stickstoffverbindung wird durch ein physikalisches Abscheiden aus der Gasphase (PVD) aufgebracht. Hierbei handelt es sich z. B. um Bedampfen, Sputtern, ein Plasmavakuumverfahren oder lonenimplantieren. Im Plasmavakuumverfahren wird die Welle 12 aus Edelstahl in einen entsprechenden Behandlungsraum eingeführt und durch Herausbrennen von Chrom-Ionen mit einem Lichtbogen aus einer Chromplatte sowie anwesenden Stickstoff-Ionen im Behandlungsraum die Chrom-Stickstoffbeschichtung auf die Edelstahlwelle 12 aufgebracht. Andere Beschichtungsverfahren z. B. eine chemische Abscheidung mittels Galvanotechnik, haben ungünstige Eigenschaften der Beschichtung zur Folge.

Die Dicke der Beschichtung liegt im Bereich von 2 bis 10 µm, insbesondere im Bereich von 5 µm. Aufgrund der großen Härte der Beschichtung (nicht dargestellt) auf der Welle 12 können in der Reinigungsflüssigkeit vorhandene Feststoffe (Suspension) nicht in die Oberfläche der Welle 12 Eindringen oder ein Aufrauhen der Oberfläche der Welle 12 verursachen. Dadurch wird die Lebensdauer der Nassläuferpumpe 14 bzw. die Zuverlässigkeit erhöht, weil keine erhöhte Reibung zwischen der Oberfläche der Welle 12 und den Lagerbuchsen 7 als Radiallager auftritt. Die Verwendung des Werkstoffes Edelstahl für die Welle 12 gewährleistet auch eine Korrosionsbeständigkeit bei einer Reinigungsflüssigkeit mit korrosionsfördernden Stoffen, z. B. Chlor oder Reinigungsmittel. Die Lagerbuchse 7 ist vorzugsweise aus gesintertem Kohlenstoff oder Kunststoff hergestellt. Die Beschichtung der Welle 12 gewährleistet auch die erforderliche Trockenlaufbeständigkeit, d. h. bei der Abwesenheit von Reinigungsflüssigkeit bzw. Wasser im Bereich der Lagerbuchsen 7. Trockenlaufbeständigkeit von Radiallagern ist in vielen Anwendungen von Nassläuferpumpen erforderlich, z. B. bei Geschirrspülmaschinen im kritischen Betriebszuständen wie Schaumbildung, Blasenbildung oder unsachgemäßem Betrieb. Das Aufbringen der Beschichtung durch ein PVD-Verfahren verschlechtert nicht die ursprüngliche Formgestaltung der Welle 12 und bietet aufgrund der Beschichtung eine festhaftende Schutzbeschichtung auch bei schwierigen Konturen.

Insgesamt betrachtet wird bei einer erfindungsgemäßen Geschirrspülmaschine eine Nassläuferpumpe zur Verfügung gestellt, deren Antriebswelle einerseits gegenüber dem Stand der Technik deutlich kostengünstiger ist und andererseits die Beständigkeit dieser Welle mit der speziellen Beschichtung gegenüber mechanischen Einwirkungen durch Feststoffteilchen und gegenüber chemischen Einwirkungen durch korrosionsfördernde Stoffe deutlich widerstandsfähiger ist. Dadurch kann die Zuverlässigkeit und Lebensdauer von Nassläuferpumpen in erfindungsgemäßen Geschirrspülmaschinen deutlich erhöht werden bei geringeren Herstellungskosten.

## Patentansprüche

1. Wasserführendes Haushaltsgerät, insbesondere Geschirrspülmaschine, mit einem beweglichen, von einem Gleitlager (7) zu lagernden Gegenstand (12), wobei der bewegliche Gegenstand eine Welle (12) ist, die von einem Radiallager (7) gelagert ist, wobei die Welle (12) von einem Elektromotor (13) antreibbar ist, wobei von der Welle (12) ein Flügelrad (2) bzw. ein Propeller (2) einer Pumpe (14) antreibbar ist, wobei die Radiallagerung (7) der Welle (12) als Nasslagerung ausgeführt ist, wobei auf der Welle (12) eine Beschichtung angeordnet ist, und wobei die Beschichtung wenigstens ein nichtmetallisches Element mit einem Stoffmengenanteil von wenigstens einem 1% umfasst und die Härte der Beschichtung wenigstens 800 HV beträgt.

2. Haushaltsgerät nach Anspruch 1, **dadurch gekennzeichnet, dass** die Härte der Beschichtung wenigstens 2.000 HV beträgt.

3. Haushaltsgerät nach Anspruch 1 oder 2, **dadurch gekennzeichnet, dass** das wenigstens eine nichtmetallischen Elemente beispielsweise ein Element aus der Gruppe der Halogene, aus der Sauerstoffgruppe oder aus der Stickstoffgruppe ist.

4. Haushaltsgerät nach einem der vorhergehenden Ansprüche, **dadurch gekennzeichnet, dass** die Beschichtung wenigstens ein metallisches Element mit einem Stoffmengenanteil von wenigstens einem 1% umfasst.

5. Haushaltsgerät nach Anspruch 4, **dadurch gekennzeichnet, dass** das wenigstens eine metallische Element beispielsweise ein Element aus der Gruppe der Alkalimetalle, der Erdalkalimetalle oder der Erdmetalle ist.

6. Haushaltsgerät nach Anspruch 4 oder 5, **dadurch gekennzeichnet, dass** das Material der Beschichtung eine chemische Verbindung ist aus wenigstens einem metallischen Element und wenigstens einem nichtmetallischen Element.

7. Haushaltsgerät nach einem der vorhergehenden Ansprüche, **dadurch gekennzeichnet, dass** die Beschichtung durch physikalisches Abscheiden aus der Gasphase (PVD-Verfahren), z. B. Bedampfen, Sputtern, Plasmavakuumverfahren oder lonenimplantieren, aufgebracht ist.

8. Haushaltsgerät nach einem der Ansprüche 1 bis 7, **dadurch gekennzeichnet, dass** die Beschichtung durch Abscheiden aus der Dampfphase, z. B. thermisches CVD, Plasma-CVD, Photonen-CVD oder laserinduziertes CVD, aufgebracht ist.

9. Haushaltsgerät nach einem der Ansprüche 1 bis 7, **dadurch gekennzeichnet, dass** die Beschichtung durch chemische Beschichtungsverfahren, z. B. Galvanisieren, aufgebracht ist.

10. Haushaltsgerät nach einem der vorherigen Ansprüche, **dadurch gekennzeichnet, dass** die Beschichtung Chrom- und/oder Stickstoff enthält, insbesondere aus einer Chrom-Stickstoffverbindung besteht.

11. Haushaltsgerät nach einem der vorherigen Ansprüche, **dadurch gekennzeichnet, dass** die Dicke der Beschichtung zwischen 0,1 µm und 20 µm, insbesondere im Bereich von 5 µm, liegt.

12. Haushaltsgerät nach einem der vorhergehenden Ansprüche, **dadurch gekennzeichnet, dass** die Radiallagerung (7) aus gesintertem Kohlenstoff besteht und vorzugsweise als gesonderte Lagerbuchse (7) ausgeführt ist.

13. Haushaltsgerät nach einem der vorhergehenden Ansprüche, **dadurch gekennzeichnet, dass** der Elektromotor (13) und/oder die Nassläuferpumpe (14) und/oder die Lagerbuchse (7) in einem Gehäuse (1, 3, 11) aus Kunststoff angeordnet sind.

14. Haushaltsgerät nach Anspruch 13, **dadurch gekennzeichnet, dass** das Gehäuse (1, 3, 11) mehrteilig ist.

15. Haushaltsgerät nach einem der vorhergehenden Ansprüche, **dadurch gekennzeichnet, dass** die Welle (12) aus Edelstahl besteht.

## Claims

1. Water-carrying domestic appliance, in particular dishwasher, having a moving object (12) to be carried by a plain bearing (7), wherein the moving object is a shaft (12) that is carried by a radial bearing (7), wherein the shaft (12) can be driven by an electric motor (13), wherein an impeller (2) or propeller (2) of a pump (14) can be driven by the shaft (12), wherein the radial bearing (7) of the shaft (12) is implemented as a wet bearing, wherein a coating is disposed on the shaft (12), and wherein the coating comprises at least one non-metallic element having a mole fraction of at least 1%, and the hardness of the coating amounts to at least 800 HV.

2. Domestic appliance according to claim 1, **characterised in that** the hardness of the coating amounts to at least 2000 HV.

3. Domestic appliance according to claim 1 or 2, **characterised in that** the at least one non-metallic element is, for example, an element from the halogen group, from the oxygen group or from the nitrogen group.

4. Domestic appliance according to one of the preceding claims, **characterised in that** the coating comprises at least one metallic element having a mole fraction of at least 1%.

5. Domestic appliance according to claim 4, **characterised in that** the at least one metallic element is, for example, an element from the group of alkali metals, alkaline earth metals or earth metals.

6. Domestic appliance according to claim 4 or 5, **characterised in that** the coating material is a chemical compound made of at least one metallic element and at least one non-metallic element.

7. Domestic appliance according to one of the preceding claims, **characterised in that** the coating is applied by physical deposition from the gas phase (PVD technique) e.g. by vapour deposition, sputtering, the plasma vacuum technique or ion implantation.

8. Domestic appliance according to one of claims 1 to 7, **characterised in that** the coating is applied by deposition from the vapour phase, e.g. thermal CVD, plasma CVD, photon CVD or laser-induced CVD.

9. Domestic appliance according to one of claims 1 to 7, **characterised in that** the coating is applied by chemical coating techniques e.g. electroplating.

10. Domestic appliance according to one of the preceding claims, **characterised in that** the coating contains chrome and/or nitrogen and, in particular, is made of a chrome-nitrogen compound.

11. Domestic appliance according to one of the preceding claims, **characterised in that** the thickness of the coating lies between 0.1 µm and 20 µm, in particular in the region of 5 µm.

12. Domestic appliance according to one of the preceding claims, **characterised in that** the radial bearing (7) is made of sintered carbon and is preferably implemented as a separate bearing bush (7).

13. Domestic appliance according to one of the preceding claims, **characterised in that** the electric motor (13) and/or the wet-running pump (14) and/or the bearing bush (7) are arranged in a plastic enclosure (1, 3, 11).

14. Domestic appliance according to claim 13, **characterised in that** the enclosure (1, 3, 11) is made of several parts.

15. Domestic appliance according to one of the preceding claims, **characterised in that** the shaft (12) is made of stainless steel.

## Revendications

1. Appareil ménager à circulation d'eau, notamment lave-vaisselle, comprenant un objet (12) mobile à loger par un palier lisse (7), l'objet mobile étant un arbre (12) qui est logé par un roulement radial (7), l'arbre (12) étant entraînable par un moteur électrique (13), une roue hélice (2) resp. une hélice (2) d'une pompe (14) étant entraînable par l'arbre (12), le roulement radial (7) de l'arbre (12) étant réalisé comme palier humide, un revêtement étant disposé sur l'arbre (12), et le revêtement comprenant au moins un élément non métallique ayant un pourcentage molaire d'au moins 1% et la dureté du revêtement étant au moins de 800 HV.

2. Appareil ménager selon la revendication 1, **caractérisé en ce que** la dureté du revêtement est au moins de 2 000 HV.

3. Appareil ménager selon la revendication 1 ou 2, **caractérisé en ce que** l'au moins un élément non métallique est par exemple un élément du groupe des halogènes, du groupe de l'oxygène ou du groupe de l'azote.

4. Appareil ménager selon l'une quelconque des revendications précédentes, **caractérisé en ce que** le revêtement comprend au moins un élément métallique ayant un pourcentage molaire d'au moins 1%.

5. Appareil ménager selon la revendication 4, **caractérisé en ce que** l'au moins un élément métallique est par exemple un élément du groupe des métaux alcalins, des métaux alcalino-terreux ou des métaux terreux.

6. Appareil ménager selon la revendication 4 ou 5, **caractérisé en ce que** la matière du revêtement est une liaison chimique constituée d'au moins un élément métallique et d'au moins un élément non métallique.

7. Appareil ménager selon l'une quelconque des revendications précédentes, **caractérisé en ce que** le revêtement est appliqué par dépôt physique en phase gazeuse (procédé PVD), par ex. vaporisation, pulvérisation, procédé plasma sous vide ou implantation ionique.

8. Appareil ménager selon l'une quelconque des revendications 1 à 7, **caractérisé en ce que** le revêtement est appliqué par dépôt en phase gazeuse, par ex. CVD thermique, CVD plasma, CVD assisté par photons ou CVD induit par laser.

9. Appareil ménager selon l'une quelconque des revendications 1 à 7, **caractérisé en ce que** le revêtement est appliqué par procédé de revêtement chimique, par ex. galvanisation.

10. Appareil ménager selon l'une quelconque des revendications précédentes, **caractérisé en ce que** le revêtement contient du chrome et/ou de l'azote, notamment **en ce qu'**il est constitué d'une liaison chrome/azote.

11. Appareil ménager selon l'une quelconque des revendications précédentes, **caractérisé en ce que** l'épaisseur du revêtement est située entre 0,1 µm et 20 µm, notamment **en ce qu'**elle est d'environ 5 µm.

12. Appareil ménager selon l'une quelconque des revendications précédentes, **caractérisé en ce que** le roulement radial (7) est constitué de carbone fritté et est réalisé de préférence en tant que coussinet (7) séparé.

13. Appareil ménager selon l'une quelconque des revendications précédentes, **caractérisé en ce que** le moteur électrique (13) et/ou la pompe à rotor noyé (14) et/ou le coussinet (7) sont disposés dans un boîtier (1, 3, 11) en matière plastique.

14. Appareil ménager selon la revendication 13, **caractérisé en ce que** le boîtier (1, 3, 11) est réalisé en plusieurs parties.

15. Appareil ménager selon l'une quelconque des revendications précédentes, **caractérisé en ce que** l'arbre (12) est constitué d'acier inoxydable.
